# FASCICULE DE BREVET EUROPEEN

(11) **EP 2 761 980 B1**
(45) Date de publication et mention de la délivrance du brevet: **15.01.2020**
(21) Numéro de dépôt: 12781131.3
(22) Date de dépôt: 25.09.2012
(51) Int. Cl.: H05K 7/14

(54) **COEUR ELECTRIQUE D'AERONEF**
STROMZENTRUM FÜR EIN FLUGZEUG
ELECTRICAL CENTER FOR AN AIRCRAFT

(30) Priorité: 30.09.2011 FR 1158829
(43) Date de publication de la demande: 06.08.2014
(73) Titulaire: Airbus Operations S.A.S., 31060 Toulouse (FR)
(72) Inventeur: GUERING, Bernard, F-31850 Montrabe (FR); DURAND, Yves, F-31840 Aussonne (FR)
(74) Mandataire: Fantin, Laurent
(86) Numéro de dépôt international: PCT/FR2012/052138
(87) Numéro de publication internationale: WO 2013/045809

(56) Documents cités:
- EP-A1- 1 793 659
- EP-A1- 2 355 637
- FR-A1- 2 872 640
- US-A1- 2009 273 234
- US-A1- 2011 127 379

## Description

La présente invention se rapporte à un cœur électrique d'aéronef.

Un cœur électrique est une armoire qui gère et distribue l'énergie électrique à bord de l'aéronef qui provient principalement des génératrices présentes sur les réacteurs, d'un générateur de puissance auxiliaire ou d'autres sources via des câbles de génération.

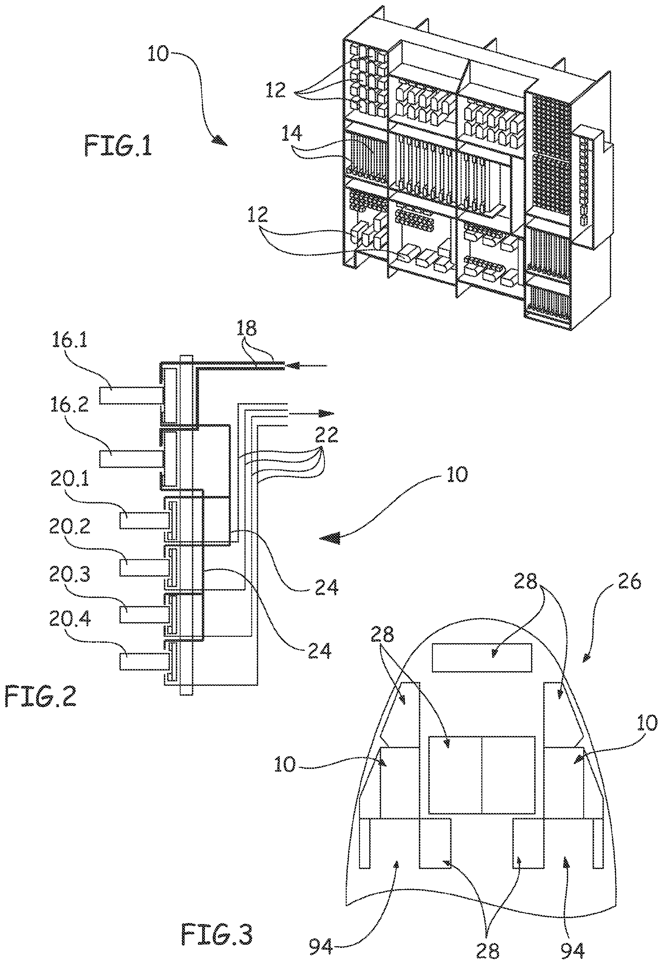

Comme illustré sur la figure 1, un cœur électrique 10 comprend des composants 12 tels que des contacteurs, des relais, des disjoncteurs, ou autres ainsi que des cartes électroniques 14. Ces nombreux composants sont liés électriquement entre eux et sont regroupés par fonction.

Pour simplifier les explications, sur la figure 2, on a représenté deux composants de génération 16.1 et 16.2 comprenant chacun une entrée reliée à un câble de génération 18 et plusieurs composants de distribution de puissance 20.1 à 20.4 dont les sorties sont reliés via des câbles de puissance 22 à des charges (non représentées) réparties dans l'aéronef. Les entrées des composants de distribution de puissance 20.1 et 20.2 sont reliées à la sortie du composant de génération 16.1 par l'intermédiaire de câbles 24 ou de barres rigides alors que les entrées des composants de distribution de puissance 20.3 et 20.4 sont reliées à la sortie du composant de génération 16.2 par l'intermédiaire de câbles 24 ou de barres rigides. Ces différents composants sont disposés au niveau d'un plan vertical qui constitue un tableau intégré dans l'armoire.

Les composants sont regroupés par modules, notamment de forme parallélépipédique, qui reposent sur des étagères. Chaque étagère se présente sous la forme d'un caisson creux dont la section est fermée, assurant notamment la reprise des efforts et la circulation de l'air prévu pour le refroidissement de l'électronique.

Le cœur électrique d'un aéronef est soumis à des contraintes dimensionnelles de plus en plus contraignantes, notamment pour les petits appareils.

En effet, compte tenu de l'agencement des composants au niveau d'un tableau vertical parallèle à la face avant de l'armoire formant le cœur électrique et de la disposition de la face avant de l'armoire parallèle à l'axe longitudinal de l'aéronef pour des raisons d'accessibilité, le cœur électrique occupe un espace important et qui le devient de plus en plus du fait des besoins croissants en énergie électrique des nouveaux appareils. Or, le ou plus précisément les cœurs électriques 10 d'un aéronef sont disposés dans la pointe avant 26 de l'appareil et doivent cohabiter avec d'autres systèmes 28 comme par exemple des calculateurs de vol, comme illustré sur la figure 3.

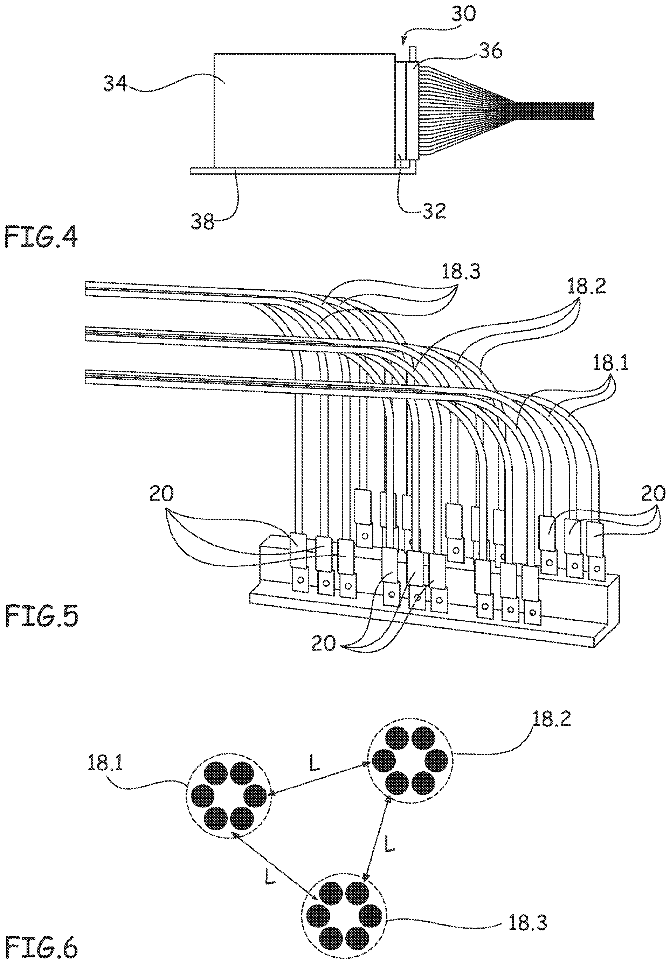

En aéronautique, il existe dans le domaine de l'avionique une norme « Arinc 600 » qui prévoit des connecteurs 30 comportant deux parties, une première partie 32 solidaire d'un boîtier 34, comme par exemple un calculateur, et une seconde partie 36 solidaire du support 38 du boîtier, comme illustré sur la figure 4. Les connecteurs prévus pour les calculateurs sont de type « rackable » à savoir ils assurent un guidage et une insertion automatique des éléments mâles d'une partie du connecteur dans les éléments femelles de l'autre partie.

Ce type de connecteur disposé au niveau de la face arrière du boîtier comprend tous les câbles électriques traités par le boîtier, à savoir les câbles entrant et sortant, et permet d'assembler un grand nombre de câbles de petite section. Ce type de connecteur est d'autant plus adapté que les boîtiers se présentent sous la forme de cartes électroniques et ne comprennent aucun câble dans le boîtier. Par conséquent, la simple transposition des connecteurs utilisés pour les calculateurs selon la norme « Arinc 600 » n'est pas envisageable en l'état à un cœur électrique dans la mesure où ce dernier comprend des câbles moins nombreux avec des sections pour certains plus importantes qui génèrent un échauffement plus important, l'échauffement et la ségrégation des câbles allant à l'encontre du compactage recherché dans les connecteurs destinés aux calculateurs.

De plus, la présence d'un seul connecteur comprenant les entrées et les sorties électriques au niveau d'une des faces du module impose la présence de câbles pour assurer le retour électrique au connecteur ce qui ne permet pas d'optimiser la densité des composants sur la hauteur du module.

Selon une autre contrainte, il est nécessaire de prévoir un espace suffisant à l'arrière du cœur électrique pour pouvoir relier par l'intermédiaire de cosses 20 les câbles de génération 18.1 à 18.3, comme illustré sur la figure 5. Ces câbles qui s'étendent depuis les motorisations jusqu'au cœur électrique ont des sections importantes compte tenu des puissances électriques transférées, ces sections étant d'autant plus importantes qu'ils sont réalisés en alliage d'aluminium pour un gain de masse. En raison de leurs sections importantes et de leurs raideurs, ces câbles ont besoin d'un rayon de courbure important et peuvent difficilement cheminer dans un volume restreint.

Comme illustré sur la figure 6, les câbles de génération 18.1 à 18.3 comprennent pour chaque phase au moins deux conducteurs ce qui tend à accroitre leurs raideurs.

Compte tenu des raideurs des câbles et du manque de précision de leurs positionnements, la distance de ségrégation L (appelée également garde) entre les câbles est importante ce qui va à l'encontre d'un cheminement dans un volume restreint.

Selon une autre problématique, le sol à l'arrière du cœur électrique 10 n'est pas plat et suit le profil du fuselage ce qui rend encore plus difficile la connexion des câbles de génération.

Le document EP2355637 décrit un meuble avionique qui comprend des étagères sur lesquelles sont positionnés des modules. Chacun d'eux comprend une unique connexion vers l'arrière qui se connecte avec une interface de connexion prévue à l'arrière du meuble. Pour chaque étagère, le meuble comprend un boitier de câblage disposé sur l'étagère relié à l'interface de connexion qui assure le retour de connexion à l'avant du meuble. Cette solution n'est pas adaptable à un cœur électrique.

Aussi, la présente invention vise à pallier les inconvénients de l'art antérieur en proposant un cœur électrique d'aéronef avec une nouvelle architecture permettant d'augmenter la densité des composants par unité de volume et d'obtenir une meilleure compacité.

A cet effet, l'invention a pour objet un cœur électrique d'un aéronef tel que défini dans la revendication 1.

D'autres caractéristiques et avantages ressortiront de la description qui va suivre de l'invention, description donnée à titre d'exemple uniquement, en regard des dessins annexés sur lesquels :
- la figure 1 est vue en perspective illustrant de manière schématique un cœur électrique d'aéronef selon l'art antérieur,
- la figure 2 est une coupe transversale illustrant de manière schématique des composants d'un cœur électrique selon l'art antérieur,
- la figure 3 est une vue de dessus de la pointe avant d'un aéronef illustrant l'emplacement des cœurs électriques,
- la figure 4 est une vue latérale illustrant de manière schématique une connexion utilisée pour relier des composants de systèmes avioniques selon l'art antérieur,
- la figure 5 est une vue d'une partie de l'arrière d'un cœur électrique selon l'art antérieur illustrant la connexion des câbles de génération,
- la figure 6 est une coupe illustrant les câbles de génération et leur espacement,
- la figure 7 est une vue de l'arrière d'un cœur électrique selon l'invention,
- la figure 8 est une coupe d'un module et d'une étagère d'un cœur électrique selon l'invention,
- la figure 9 est une vue en perspective illustrant une extension d'un cœur électrique selon l'invention,
- la figure 10 est une vue en perspective illustrant de manière schématique une extension d'un cœur électrique selon l'invention,
- la figure 11 est une coupe transversale d'une extension d'un cœur électrique,
- la figure 12 est une coupe transversale illustrant des détails d'une extension d'un cœur électrique,
- la figure 13 est une représentation schématique d'un exemple d'intégration d'un cœur électrique selon l'invention et de meubles électriques et/ou électroniques dans un cockpit d'un aéronef.

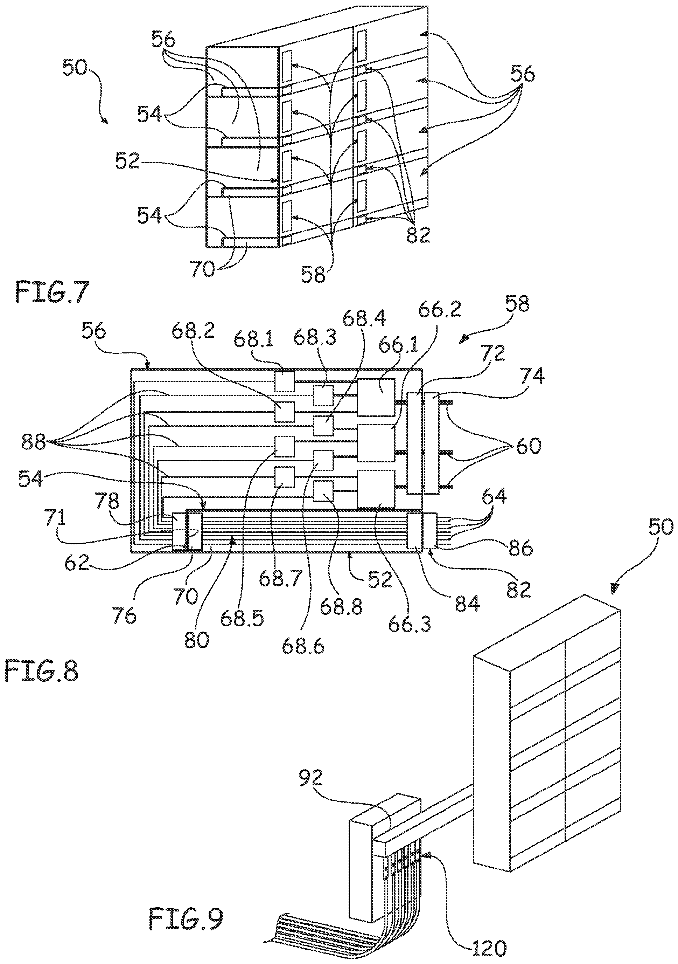

Sur la figure 7, on a représenté un cœur électrique 50 selon l'invention. Ce dernier comprend une structure porteuse 52 comprenant des étagères 54 supportant chacune au moins un module 56. Comme illustré sur la figure 8, un module 56 comprend au moins une entrée susceptible d'être reliée par l'intermédiaire d'une première connexion 58 à au moins un câble d'alimentation 60 et au moins une sortie susceptible d'être reliée par l'intermédiaire d'une deuxième connexion 62 à au moins un câble de sortie 64.

Selon l'exemple illustré sur la figure 8, le module 56 est relié à au moins un câble de génération 60 et comprend des sorties sous forme de câbles primaires 64. Un module 56 regroupe au moins deux composants disposés selon la direction parallèle à la profondeur du cœur électrique et traversés successivement par le courant électrique.

A l'intérieur des modules, des conducteurs rigides peuvent être prévus pour relier les différents composants entre eux.

Selon un mode de réalisation, ces composants sont identiques à ceux implantés sur un tableau d'un cœur électrique de l'art antérieur. Ainsi, l'invention ne vise pas à modifier les composants d'un cœur électrique mais leurs agencements. Toutefois, les formes et les agencements des composants pourraient être modifiés.

A titre d'exemple, sur la figure 8, un module comprend trois composants de génération 66.1 à 66.3 comprenant chacun une entrée reliée à un câble de génération 60 et plusieurs composants de distribution de puissance 68.1 à 68.8 dont les sorties sont reliées via des câbles de puissance à des charges (non représentées) réparties dans l'aéronef. Les entrées des composants de distribution de puissance 68.1 à 68.3 sont reliées à la sortie du composant de génération 66.1 par l'intermédiaire de câbles ou de barres rigides, les entrées des composants de distribution de puissance 68.4 à 68.6 sont reliées à la sortie du composant de génération 66.2 par l'intermédiaire de câbles ou de barres rigides, les entrées des composants de distribution de puissance 68.7 et 68.8 sont reliées à la sortie du composant de génération 66.3 par l'intermédiaire de câbles ou de barres rigides.

Ainsi, contrairement à l'art antérieur qui prévoit de les agencer sur un tableau, l'invention propose d'incorporer les composants dans une structure volumique appelée module 56. De ce fait, les composants sont également disposés selon la profondeur du cœur électrique 50 ce qui permet de réduire les dimensions de la face avant du cœur électrique à nombre de composants identique.

Selon un point de l'invention, le traitement de la fonction électrique dans le module 56 est réalisé en circuit direct. Ainsi, l'entrée du circuit électrique via la première connexion 58 est située à l'arrière du cœur électrique alors que les sorties via la deuxième connexion 62 sont prévues au niveau de la face avant après traitement dans les composants de génération, les composants de distribution de puissance et multiplication des sorties.

Selon une caractéristique importante de l'invention, pour au moins un module 56, le ou les câbles de sortie 64 transitent sous ou dans l'étagère 54 disposée sous le module. Cet agencement permet d'augmenter la densité des composants dans un module car les composants peuvent être répartis sur toute la hauteur du module dans la mesure où les circuits électriques ne font pas une boucle à l'intérieur du module 56.

Avantageusement, les câbles de sortie 64 cheminent dans la partie creuse 70 de l'étagère 54 qui contrairement à l'art antérieur est ouverte au niveau des faces avant et arrière.

Selon un point de l'invention, on utilise la structure porteuse et plus particulièrement les étagères 54 pour loger le retour des câbles de sortie vers la face arrière du cœur électrique. Selon cet agencement, le cœur électrique est constitué d'une superposition de volumes, un volume dédié au module et un volume correspondant à l'étagère. De la sorte, toute la hauteur du cœur électrique est utilisée pour la connexion des câbles ce qui contribue à augmenter la densité des composants dans le module. De plus, cet agencement permet d'obtenir une bonne ségrégation entre les câbles de génération et les câbles de puissance, les câbles de différents types étant disposés à des hauteurs différentes.

Selon un mode de réalisation, le cœur électrique comprend des moyens de ventilation pour refroidir les câbles circulant dans les étagères 70.

Selon un mode de réalisation, chaque module 56 comprend une première partie sensiblement parallélépipédique avec une profondeur supérieure à celle de l'étagère et une excroissance en partie inférieure dont la hauteur est sensiblement égale à celle de l'étagère de manière à ce que le module dispose d'une face 71 au regard du chant de l'étagère.

Pour faciliter la connectique, le cœur électrique comprend pour le ou les câbles d'alimentation 60 de chaque module 56 une première connexion 58 située au niveau de la face arrière du cœur électrique avec une première partie 72 solidaire du module 56 susceptible de coopérer avec une seconde partie 74 prévue à l'extrémité du ou des câbles d'alimentation 60 et éventuellement solidaire de la structure porteuse. Avantageusement, la première connexion 58 est un connecteur de type « rackable » qui assure un guidage et une insertion automatique des éléments mâles d'une partie du connecteur dans les éléments femelles de l'autre partie.

En complément, le cœur électrique comprend, pour chaque module 56, une deuxième connexion 62 pour le ou les câbles de sortie 64 située au niveau de la face 71 du module avec une première partie 76 solidaire de la structure porteuse 52 et une seconde partie 78 prévue au niveau du module 56.

Avantageusement, la seconde connexion 62 est un connecteur de type « rackable » qui assure un guidage et une insertion automatique des éléments mâles d'une partie du connecteur dans les éléments femelles de l'autre partie.

Le fait que les connexions 58 et 62 soient des connecteurs de type « rackable » simplifie le montage et le démontage des modules 56 lors de la fabrication de l'aéronef ou de sa maintenance.

Pour simplifier le câblage, la structure porteuse 52 peut être précâblée et comprendre, pour au moins un module, dans l'étagère 54 située dessous, un faisceau de câbles 80 qui s'étend entre deux parties de deux connexions prévues au niveau des chants opposés de l'étagère. Ainsi les câbles de sortie comprennent un premier tronçon qui correspond au faisceau de câbles.

Selon ce mode de réalisation, le cœur électrique comprend une troisième connexion 82 située au niveau de la face arrière du cœur électrique, notamment sous la première connexion 58.

Cette troisième connexion 82 comprend une première partie 84 prévue à l'extrémité du faisceau de câble 80 susceptible de coopérer avec une seconde partie 86 prévue aux extrémités du ou des câbles de sortie 64.

Le faisceau de câbles 80 comprend un nombre de câbles identique, voire supérieur à celui des câbles 88 sortant du module 56.

Selon une autre caractéristique de l'invention, il est possible d'augmenter la profondeur du cœur électrique 50 et de profiter de cette profondeur supplémentaire pour augmenter la densité des composants dans le cœur électrique dans la mesure où les câbles de génération provenant notamment des génératrices des réacteurs ne sont pas reliés directement à la face arrière du cœur électrique mais au niveau d'au moins une extension 90 qui s'étend depuis l'arrière du cœur électrique jusqu'à une platine de connexion 92 décalée par rapport à au moins un des côtés dudit cœur électrique. Ainsi, il n'est pas nécessaire de prévoir un espace important entre la face arrière du cœur électrique et la paroi du fuselage pour assurer la connexion des câbles de génération.

Avantageusement, la platine de connexion 92 est disposée dans la zone 94 correspondant à un centre de connexion latéral visible sur la figure 3.

Cette zone 94 est plus accessible que la zone située à l'arrière du cœur électrique et offre un sol plat qui améliore les conditions de travail des opérateurs chargés de l'industrialisation ou de la maintenance.

Selon l'invention, l'extension comprend pour chaque phase de chaque ligne de génération un élément conducteur électrique 96 en cuivre.

Pour la suite de la description, on entend par cuivre aussi bien du cuivre qu'un alliage de cuivre.

L'extension 90 constitue une partie intégrante du cœur électrique 50. Par conséquent, le gain en volume étant prioritaire sur le gain de masse, il est possible de ne prévoir qu'un seul élément conducteur avec une section importante par phase pour chaque ligne de génération contrairement aux câbles de génération en alliage d'aluminium qui comprennent au moins deux éléments conducteurs avec une section inférieure par phase pour limiter l'échauffement des éléments conducteurs.

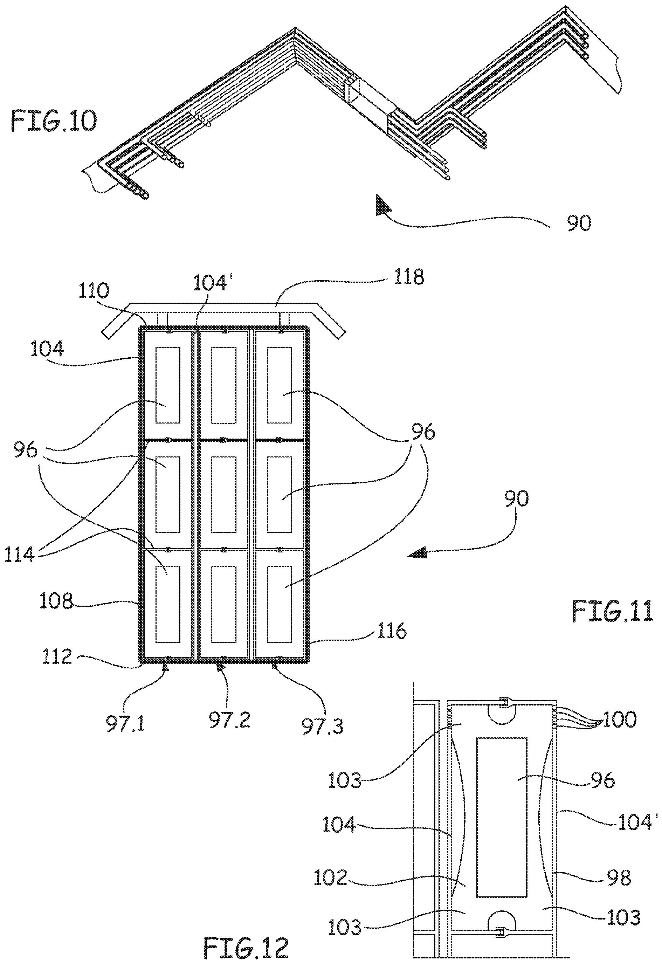

A titre d'exemple sur la figure 11, on a représenté neuf conducteurs électriques, trois phases pour trois lignes de génération 97.1, 97.2 et 97.3.

Le fait d'utiliser comme matériau du cuivre au lieu d'un alliage d'aluminium confère aux éléments conducteurs 96 une aptitude au pliage plus importante avec des rayons de pliage de l'ordre de 1 à 2 mm possible.

Selon un autre avantage, le cuivre a une dilatation thermique plus faible que les alliages d'aluminium utilisés pour réaliser les câbles de génération selon l'art antérieur.

Selon une autre caractéristique, les éléments conducteurs 96 sont rigides et se présentent chacun sous la forme d'une barre rigide en cuivre.

Le fait de prévoir des éléments rigides permet de réduire la garde entre chaque élément conducteur.

Selon une autre caractéristique de l'invention, chaque élément conducteur 96 est disposé dans un conduit rigide 98 en un matériau isolant électriquement, le conduit rigide 98 ayant une section suffisante pour que l'élément conducteur soit séparé de la face intérieure du conduit par une lame d'air concentrique à l'élément conducteur 96.

Cette lame d'air favorise également le refroidissement des éléments conducteurs 96. Selon un premier point, dans la mesure où chaque conduit rigide 98 communique avec l'intérieur du cœur électrique et que l'intérieur de ce dernier est ventilé par une ventilation forcé, un flux d'air forcé est produit à l'intérieur de chaque conduit 98. Selon un autre point, des orifices 100 (visibles sur la figure 12) sont pratiqués régulièrement sur chaque conduit 98 pour améliorer encore la ventilation des éléments conducteurs 96.

Avantageusement, des plots 102 sont prévus à l'intérieur du conduit 98, répartis à intervalles réguliers, pour maintenir l'écartement tout autour de l'élément conducteur 96.

Selon un mode de réalisation, ces plots 102 sont en silicone. Chaque plot comprend un orifice central dont la section est ajustée à celle de l'élément conducteur 96 et au niveau de sa périphérie des excroissances 103 dont les formes extérieures sont ajustées à la section du conduit 98. Entre les excroissances 103, l'air peut circuler le long du conduit 98.

Ces plots 102 assurent également un filtrage vibratoire.

Selon un mode de réalisation, les éléments conducteurs ont une section rectangulaire et comprennent une protection de surface isolante. Les conduits rigides 98 ont également une section rectangulaire.

Avantageusement, un conduit rigide 98 est constitué de deux demi-coquilles 104, 104' assemblées.

Selon un mode de réalisation, les demi-coquilles sont approximativement symétriques selon un plan médian 106, de préférence vertical. Chaque demi coquille comprend une première paroi latérale 108, une paroi supérieure 110 et une paroi inférieure 112 perpendiculaires à la paroi latérale 108 ainsi que deux cloisons 114 perpendiculaires à la paroi latérale 108 et réparties de manière régulière entre les parois supérieure 110 et inférieure 112.

Les bords libres des parois supérieure et inférieure ainsi que des cloisons des demi-coquilles ont des formes qui coopèrent pour assurer la liaison entre les deux demi-coquilles. De préférence, les deux demi-coquilles 104 et 104' sont identiques et assemblées tête-bêche. Ainsi, selon un mode de réalisation, les bords libres de la paroi supérieure et d'une des deux cloisons comprennent des fentes aptes à recevoir les bords libres de l'autre demi-coquille.

Selon l'invention, les phases d'une ligne de génération sont isolées entre elles en étant disposées dans les conduits 98 formés par deux demi-coquilles 104 et 104' assemblées. Les lignes de génération sont isolées entre elles en étant disposées dans des jeux de demi-coquilles différents. Ainsi, pour trois lignes de génération, on prévoit trois jeux de deux demi-coquilles, un espace étant ménagé entre les jeux de deux demi-coquilles.

Les trois jeux de demi-coquilles sont maintenus assemblés par une bride de maintien 116. Ainsi, l'extension 90 a une section sensiblement rectangulaire.

De préférence, un déflecteur 118 est prévu au-dessus de l'ensemble des conduits 98 pour les protéger des ruissèlements de liquide.

De préférence, l'extension 90 comprend à chaque extrémité de chaque élément conducteur un dispositif de protection différentielle comme par exemple un bobinage de type à effet Hall.

Sur le plan de la connectique, l'extrémité de chaque élément conducteur est reliée au cœur électrique par un contact de puissance, par exemple par une connexion de type « pinouille » mâle/femelle de grosse section. L'autre extrémité de chaque élément conducteur est reliée à l'élément conducteur correspondant d'un des câbles de génération, au niveau de la platine de connexion, par un raccordement de type bornier 120.

Même si le cuivre a un coefficient de dilatation faible, il est de préférence souhaitable de prévoir des moyens pour absorber les variations de longueurs des éléments conducteurs 96.

En ce sens, les moyens de raccordement entre les éléments conducteurs des câbles de génération et les éléments conducteurs des lignes de génération de l'extension sont montés flottants sur la platine de connexion 92.

En variante ou en complément, l'extension 90 comprend un profil en Z selon sa longueur avec un double pliage à 90° de manière à absorber les variations de longueurs des éléments conducteurs en raison des phénomènes de dilatation.

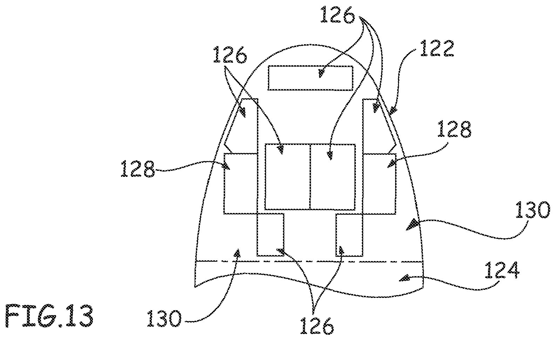

Selon l'invention, il est possible d'intégrer l'ensemble du matériel électrique habituellement disposé dans la soute prévue sous le cockpit dans le volume du cockpit en le faisant cohabiter avec les autres éléments normalement présents dans ledit cockpit, comme illustré sur la figure 13.

Ainsi, dans un cockpit 122 disposé à l'avant d'une cabine 124, il est possible d'intégrer des meubles électriques et/ou électroniques comme des meubles systèmes 126 ou des coeurs électriques 128.

De même, il est possible d'organiser ces différents meubles électriques et/ou électroniques de manière à dégager au niveau de la jonction entre la cabine 124 et la pointe avant contenant le cockpit 122 au moins un centre de connexion 130, de préférence un de chaque côté de l'aéronef, accessible améliorant le confort des opérateurs chargés de l'installation ou de l'entretien du réseau électrique de l'aéronef. Selon cet agencement, le réseau électrique de la cabine est relié grâce à des moyens de connexion au réseau électrique de la pointe avant de l'aéronef, ces moyens de connexion étant disposés au niveau du ou des centre(s) de connexion 130. Ainsi, il est possible d'intégrer le réseau électrique de la cabine indépendamment du réseau électrique du cockpit et de les relier par la suite au niveau d'une zone de connexion accessible.

## Revendications

1. Coeur électrique d'un aéronef comportant :
- au moins une étagère (54),
- au moins un module (56) de génération et de distribution de puissance électrique, disposé sur l'étagère (54), contenant des composants et comprenant au moins une entrée et au moins une sortie,
- au moins un câble d'alimentation (60) relié à l'entrée du module (56),
- au moins un câble de sortie (64) sous forme de câble primaire relié à la sortie du module (56),
**caractérisé en ce que**
pour un module (56), l'étagère disposée sous le module a une structure creuse et **en ce que**:
chaque module (56) comprend une première partie sensiblement parallélépipédique avec une profondeur supérieure à celle de l'étagère et une excroissance en partie inférieure dont la hauteur est sensiblement égale à celle de l'étagère de manière à ce que le module dispose d'une face (71) au regard du chant de l'étagère;
chaque module (56) comprend une connexion (62) pour le ou les câbles de sortie (64) située au niveau de la face (71) du module;
le ou les câbles de sortie (64) ou un faisceau (80) de câbles correspondant à un tronçon du ou des câble(s) de sortie (64) cheminent dans la partie creuse (70) de l'étagère (54) disposée sous le module.

2. Cœur électrique selon la revendication 1, **caractérisé en ce qu'**il comprend pour chaque module d'une part une première connexion (58) pour le ou les câbles d'alimentation (60) située au niveau d'une première face du cœur électrique avec une première partie (72) solidaire du module (56) susceptible de coopérer avec une seconde partie (74) prévue à l'extrémité du ou des câbles d'alimentation (60), et d'autre part, une deuxième connexion (62) pour le ou les câbles de sortie (64) située au niveau de la face (71) du module avec une première partie (76) et une seconde partie (78) prévue au niveau du module (56).

3. Cœur électrique selon la revendication 2, **caractérisé en ce que** la première connexion (58) et la seconde connexion (62) sont des connecteurs de type « rackable » qui assurent un guidage et une insertion automatique des éléments mâles d'une partie du connecteur dans les éléments femelles de l'autre partie.

4. Cœur électrique selon l'une des revendications 1 à 3, **caractérisé en ce qu'**il comprend pour un module (56) un faisceau (80) de câbles disposé dans la partie creuse (70) de l'étagère avec à une première extrémité située au niveau d'un premier chant de l'étagère une connexion (62) pour le relier au module (56) et à une seconde extrémité située au niveau de l'autre chant de l'étagère une connexion (82) pour le relier à un ou aux câbles de sortie (64).

5. Cœur électrique selon l'une des revendications précédentes, **caractérisé en ce qu'**un module (56) regroupe au moins deux composants disposés selon la direction parallèle à la profondeur du cœur électrique et traversés successivement par le courant électrique.

## Patentansprüche

1. Elektrische Zentrale eines Luftfahrzeugs mit:
- wenigstens einer Ablage (54),
- wenigstens einem Modul (56) zum Erzeugen und Verteilen von elektrischer Energie, das auf der Ablage (54) angeordnet ist und Komponenten enthält und wenigstens einen Eingang und wenigstens einen Ausgang aufweist,
- wenigstens einem Versorgungskabel (60), das mit dem Eingang des Moduls (56) verbunden ist,
- wenigstens einem Ausgangskabel (64) in der Gestalt einer Einzeladerleitung, die mit dem Ausgang des Moduls (56) verbunden ist,
**dadurch gekennzeichnet, dass**
für ein Modul die unter dem Modul angeordnete Ablage (56) eine Hohlstruktur hat,
und dass:
jedes Modul (56) einen im Wesentlichen quaderförmigen ersten Teil aufweist, der über eine größere Tiefe als die Ablage (54) verfügt, und im unteren Bereich eine Erweiterung aufweist, deren Höhe im Wesentlichen gleich der Höhe der Ablage ist, so dass auf diese Weise das Modul über eine Seite (71) verfügt, die der Schmalseite der Ablage gegenüberliegt;
jedes Modul (56) eine Verbindung (62) für das oder die im Bereich der Seite (71) des Moduls angeordnete(n) Ausgangskabel (64) aufweist;
das oder die Ausgangskabel (64) oder ein Kabelbündel (80), die einem Abschnitt des oder der Ausgangskabel (64) entsprechen, in dem Hohlbereich (70) der unter dem Modul angeordneten Ablage (54) verlaufen.

2. Elektrische Zentrale nach Anspruch 1,
**dadurch gekennzeichnet, dass** diese für jedes Modul einerseits eine erste Verbindung (58) für das oder die Versorgungskabel (60) aufweist, die sich im Bereich einer ersten Seite der elektrischen Zentrale befinden und einen am Modul (56) angebrachten ersten Teil (72) aufweisen, der dazu geeignet ist, mit einem zweiten Teil (74) zusammenzuwirken, das am Ende des oder der Versorgungskabel (60) vorgesehen ist, und andererseits eine zweite Verbindung (62) für das oder die Ausgangskabel (64) aufweist, die sich im Bereich der Seite (71) des Moduls befinden und ein erstes Teil (76) und ein zweites Teil (78) aufweisen, das im Bereich des Moduls (56) vorgesehen ist.

3. Elektrische Zentrale nach Anspruch 2,
**dadurch gekennzeichnet, dass** die erste Verbindung (58) und die zweite Verbindung (62) Stecker vom Typ "rackable" sind, die eine Führung und ein automatisches Einführen der auf der einen Seite männlichen Elemente des Steckers in die auf der anderen Seite weiblichen Elemente gewährleistet.

4. Elektrische Zentrale nach einem der Ansprüche 1 bis 3, **dadurch gekennzeichnet, dass** diese für ein Modul (56) ein Kabelbündel (80) aufweist, das im Hohlbereich (70) der Ablage angeordnet ist und das im Bereich eines ersten Endes, das sich im Bereich einer ersten Schmalseite der Ablage befindet, über eine Verbindung (62) verfügt, um dieses mit dem Modul (56) zu verbinden, und das an einem zweiten Ende, das sich im Bereich der anderen Schmalseite der Ablage befindet, über eine Verbindung (62) verfügt, um dieses mit einem oder mehreren Ausgangskabel(n) (64) zu verbinden.

5. Elektrische Zentrale nach einem der vorhergehenden Ansprüche, **dadurch gekennzeichnet, dass** ein Modul (56) wenigstens zwei in der Tiefe der elektrischen Zentrale in paralleler Richtung angeordnete Komponenten aufweist, die nacheinander vom elektrischen Strom durchflossen sind.

## Claims

1. Electrical core of an aircraft comprising:
- at least one shelf (54),
- at least one module (56) for generating and distributing electrical power, disposed on the shelf (54), containing components and comprising at least one input and at least one output,
- at least one power supply cable (60) connected to the input of the module (56),
- at least one output cable (64) in the form of primary cables connected to the output of the module (56),
**characterized in that**
for a module (56), the shelf arranged under the module has a hollow structure and **in that**:
each module (56) comprises a first parallelepipedal part with a depth greater than that of the shelf and a protuberance in the lower part whose height is substantially equal to that of the shelf in such a way that the module has a face (71) overlooking the lip of the shelf;
each module (56) comprises a connection (62) for the output cable or cables (64) arranged on the face (71) of the module;
the output cable or cables (64) or a bundle (80) of cables corresponding to a first segment of the output cable or cables (64) run in the hollow structure (70) of the shelf (54) disposed under the module.

2. Electrical core according to Claim 1, **characterized in that** it comprises for each module on the one hand a first connection (58) for the power supply cable or cables (60), situated at a first face of the electrical core, with a first part (72) secured to the module (56) able to cooperate with a second part (74) provided at the end of the power supply cable or cables (60), and on the other hand, a second connection (62) for the output cable or cables (64), situated at the face (71) of the module, with a first part (76) and a second part (78) provided at the module (56).

3. Electrical core according to Claim 2, **characterized in that** the first connection (58) and the second connection (62) are connectors of "rackable" type which ensure automatic guidance and insertion of the male elements of one part of the connector into the female elements of the other part.

4. Electrical core according to any one of Claims 1 to 3, **characterized in that** it comprises for a module (56) a bundle (80) of cables disposed in the hollow part (70) of the shelf with at a first end situated at a first lip of the shelf a connection (62) for linking it to the module (56) and at a second end situated at the other lip of the shelf a connection (82) for linking it to a or to the output cables (64).

5. Electrical core according to any one of the preceding claims, **characterized in that** a module (56) groups together at least two components disposed in the direction parallel to the depth of the electrical core and traversed successively by the electric current.
